# EUROPEAN PATENT APPLICATION

(11) **EP 4 553 897 A1**
(43) Date of publication of application: **14.05.2025**
(21) Application number: 24182904.3
(22) Date of filing: 18.06.2024
(51) Int. Cl.: H01L 23/528, H01L 27/02, H01L 29/06, H10B 10/00

(54) **INTEGRATED CIRCUIT DEVICE**

(30) Priority: 09.11.2023 KR 20230154739
(71) Applicant: Samsung Electronics Co., Ltd., Suwon-si, Gyeonggi-do 16677 (KR)
(72) Inventor: KIM, Jeewoong, 16677 Suwon-si (KR); LEE, Seunghun, 16677 Suwon-si (KR); LEE, Kyowook, 16677 Suwon-si (KR); CHO, Keunhwi, 16677 Suwon-si (KR)
(74) Representative: Marks & Clerk LLP

(57) **Abstract**

Provided is an integrated circuit device with reduced line margins. The integrated circuit device includes an active area on a substrate, a channel area in the active area, a gate line that extends around the channel area, a plurality of first upper lines that electrically connect the channel area and the gate line to each other, a plurality of first lower lines of a side of the substrate, and a second lower wiring line on a side of the plurality of first lower lines that is opposite the substrate. The plurality of first lower lines includes a jog pattern line and an island pattern line that is spaced apart from the jog pattern line, and the island pattern line is electrically connected to the second lower wiring line by a lower contact.

## Description

### BACKGROUND

The inventive concept relates to integrated circuit devices. More specifically, the inventive concept relates to an integrated circuit device including a back-side power delivery network (BSPDN).

With the advancement of electronic technology, down-scaling of integrated circuit devices has rapidly progressed. In addition, in order to improve the degree of integration of integrated circuit devices, integrated circuit devices including a BSPDN have been studied.

### SUMMARY

The inventive concept provides an integrated circuit device with improved design freedom.

In addition, the objective of the inventive concept is not limited to the objective mentioned above, and other objectives could be clearly understood by a person skilled in the art from the description below.

The inventive concept provides an integrated circuit device as described below.

According to some embodiments of the inventive concept, there is provided an integrated circuit device including a fin-type active area on a substrate, a channel area in the fin-type active area, a gate line that extends around the channel area fin-type, a plurality of first upper lines that electrically connect the channel area and the gate line to each other, a plurality of first lower lines on a side of the substrate, and a second lower wiring line on a side of the plurality of first lower lines that is opposite the substrate, wherein the plurality of first lower lines include a jog pattern line and an island pattern line that is spaced apart from the jog pattern line, and the island pattern line is electrically connected to the second lower wiring line by a lower contact.

According to some embodiments of the inventive concept, there is provided an integrated circuit device including a substrate having a front surface and a rear surface that are opposite to each other, and having an fin-type active area on the front surface, the fin-type active area adjacent a trench, source/drain regions on the fin-type active area, gate electrodes that extend across the fin-type active area, a plurality of first upper lines that are on the source/drain regions and electrically connected to the source/drain regions by at least one via, a plurality of first lower lines below the substrate (e.g. on a side of the substrate), and a second lower wiring line below the plurality of first lower lines, and on a side of the second island pattern line. The second lower wiring line may be on a side of the plurality of first lower lines that is opposite the substrate. The integrated circuit device comprises a third lower wiring line below the second lower wiring line (e.g. on a side of the second lower wiring line that is opposite the first lower lines). The plurality of first lower lines include a jog pattern line and a first island pattern line that is spaced apart from the jog pattern line, the first island pattern line is electrically connected to the second lower wiring line and the third lower wiring line by a first lower contact, and the jog pattern line is electrically connected to the second island pattern line by the first lower contact, and is electrically connected to the third lower wiring line by a second lower contact.

According to some embodiments of the inventive concept, there is provided an integrated circuit device including a plurality of nanosheets, a plurality of gate lines, a plurality of transistors at respective intersections of ones of the plurality of nanosheets and ones of the plurality of gate lines, the plurality of transistors including at least a portion included in a static random access memory (SRAM), a plurality of first upper lines in a first layer that is different from a second layer of the plurality of transistors, and electrically connected to a source/drain region of at least one of the plurality of transistors by at least one via, a plurality of first lower lines on a third layer that is on a side of the second layer of the plurality of transistors that is opposite the first layer, and a second lower line pattern on a a fourth layer that is adjacent the third layer of the plurality of first lower lines and opposite the second layer. The second lower line pattern includes a wiring line of at least one layer, and when the wiring line includes two or more layers that are in different layers from each other, the plurality of first lower lines include a jog pattern line and an island pattern line that is spaced apart from the jog pattern line, and the island pattern line is electrically connected to the second lower line pattern by a lower contact.

A jog pattern line may be a line having a zig-zag or crenellated shape. An island pattern line may be a line having an island shape (e.g. a circle, square, etc). A jog pattern line may extend in an extension direction (e.g. a first direction D 1) and include concavo-convex portions that result in portions that extend laterally (e.g. in a second direction D2, crossing the first direction D1). An island pattern line may be positioned within each concave section. Each jog pattern line therefore may bend around a corresponding series of island pattern lines. Given the zig-zag pattern of the jog pattern line, island patterns lines may alternate on opposite sides of the jog pattern line. The concavo-convex portions may alternate their direction of protrusion, in order, down the length of the jog pattern line. The jog pattern line may be a word line.

At least some of the above and other features of the invention are set out in the claims.

### BRIEF DESCRIPTION OF THE DRAWINGS

Embodiments of the inventive concept will be more clearly understood from the following detailed description taken in conjunction with the accompanying drawings in which:
FIG. 1 is a circuit diagram illustrating an integrated circuit according to some embodiments;
FIG. 2 is a conceptual diagram illustrating a stack structure of an integrated circuit device according to some embodiments;
FIG. 3 is a planar layout illustrating a unit cell of an integrated circuit device according to some embodiments;
FIG. 4A is a cross-sectional view corresponding to line A-A' in FIG. 3, and FIG. 4B is a cross-sectional view corresponding to line B-B' in FIG. 3;
FIG. 5A is a 4-bit layout diagram briefly illustrating example shapes of a jog pattern line and an island pattern line according to some embodiments, which are formed between mutually adjacent unit cells;
FIG. 5B is a 4-bit layout diagram briefly illustrating an example shape of an upper wiring line according to some embodiments, formed between mutually adjacent unit cells;
FIGS. 5C, 5D, and 5E are 4-bit layout diagrams briefly illustrating an example shape of a second lower line according to some embodiments, formed between mutually adjacent unit cells;
FIG. 6 is a planar layout diagram illustrating a unit cell of an integrated circuit device according to some embodiments; and
FIG. 7 is a planar layout illustrating a unit cell of an integrated circuit device according to some embodiments.

### DETAILED DESCRIPTION

Hereinafter, embodiments are described in detail with reference to the accompanying drawings. In the drawings, the same reference characters are used for the same element, and redundant descriptions thereof are omitted.

Because embodiments may be modified in various ways and have various embodiments, specific embodiments are illustrated in the drawings and described in detail in the detailed description. However, this is not intended to limit the scope to specific embodiments, and should be construed to include all transformations, equivalents, and substitutes included in the scope of the claims. In describing the embodiments, when it is determined that detailed description of related known technologies may obscure the gist, the detailed description thereof is omitted.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

It is to be understood that when an element or layer is referred to as being "over", "above", "on", "below", "under", "beneath", "connected to" or "coupled to" another element or layer, it can be directly over, above, on, below, under, beneath, connected or coupled to the other element or layer or intervening elements or layers may be present. In contrast, when an element is referred to as being "directly over", "directly above", "directly on", "directly below", "directly under", "directly beneath", "directly connected to" or "directly coupled to" another element or layer, there are no intervening elements or layers present.

The terms "upper", "middle", "lower" may refer to relative positions along a particular direction (e.g. a vertical direction). Various directions (e.g. vertical direction, horizontal direction, etc.) may be defined relative to the structure of the devices described herein. It will be appreciated that these directions do not necessarily imply any particular orientation of the device in use. For instance, a vertical direction may be defined perpendicular to an upper or lower surface of a substrate. One or more horizontal directions may be defined perpendicular to the vertical direction. The vertical direction may define a height direction of the device. Accordingly, an "upper" feature may be located further along the height direction than a "lower" feature. Similarly, a "top" of a component (e.g. a substrate) may be located further along the height direction than a "bottom" of a component.

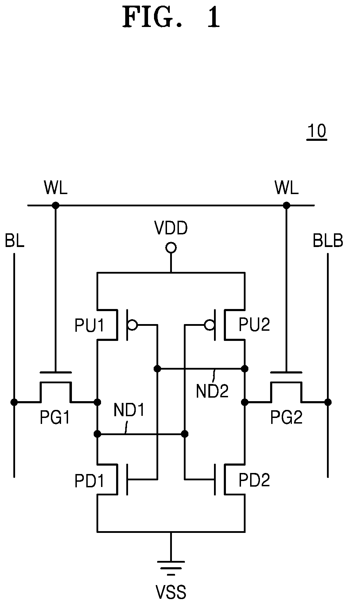

FIG. 1 is a circuit diagram illustrating an integrated circuit 10 according to some embodiments.

Referring to FIG. 1, as shown in the circuit diagram, the integrated circuit 10 having a field-effect transistor (FET) of a three-dimensional stack structure may be a static random access memory (SRAM) device including six transistors. However, this is only an example, and the inventive concept is not limited thereto. The integrated circuit 10 may also be applicable to an SRAM including more than six transistors.

The integrated circuit 10 may include, for example, a first pass gate transistor PG1, a second pass gate transistor PG2, a first pull-up transistor PU1, a second pull-up transistor PU2, a first pull-down transistor PD1, and a second pull-down transistor PD2.

In some embodiments, gates of the second pull-up transistor PU2 and the second pull-down transistor PD2 and a bit line BL may be connected to source/drain areas of the first pass gate transistor PG1. In addition, gates of the first pull-up transistor PU1 and the first pull-down transistor PD1 and a bit line bar BLB may be connected to source/drain areas of the second pass gate transistor PG2.

In some embodiments, the first pass gate transistor PG1, the second pass gate transistor PG2, the first pull-down transistor PD1, and the second pull-down transistor PD2 may be formed as n metal-oxide-semiconductor field-effect transistors (MOSFETs) (nMOSFETs), and the first pull-up transistor PU1 and the second pull-up transistor PU2 may be formed as pMOSFETs. In addition, the first pull-up transistor PU1 and the first pull-down transistor PD1 and the second pull-up transistor PU2 and the second pull-down transistor PD2 may be a storage element of the integrated circuit 10.

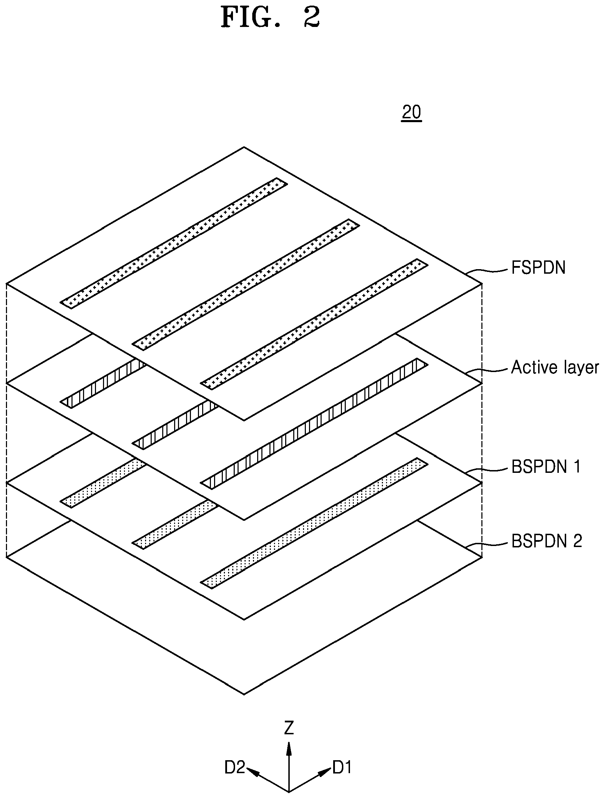

FIG. 2 is a conceptual diagram illustrating a stack structure of an integrated circuit device according to some embodiments.

Referring to FIG. 2, an integrated circuit 20 may include a second back-side power delivery network BSPDN2, a first back-side power delivery network BSPDN1, a transistor layer (active layer), and a front-side power delivery network FSPDN in that order (e.g. in a vertical direction). In FIG. 2, a layer on which a transistor is positioned (the active layer) includes one layer. However, this is only an illustration, and the layer on which the transistor is positioned (the active layer) may include two or more layers. In addition, it is shown that the back-side power delivery network includes two layers. However, this is only an illustration, and three or more back-side power delivery networks may be formed.

In the inventive concept, a power transmission delivery network may be provided under a lower metal layer that is disposed under a substrate. The power transmission delivery network may include a plurality of lower lines, and in particular, may include a jog type metal line and an island type metal line, as described below. By placing some lines that function as word lines under the substrate, line congestion within the device may be reduced.

A transistor layer (active layer) may be formed on a semiconductor substrate (not shown). The front-side power delivery network FSPDN may be stacked over the transistor layer (active layer) toward the top of the substrate and electrically connected to supply signals and power, and the first and second back-side power delivery networks BSPDN1 and BSPDN2 may be positioned under the transistor layer (active layer). As shown in FIG. 2, signal and power patterns may be formed in the front-side power delivery network FSPDN, and signal and power patterns may be formed in the first and second back-side power delivery networks BSPDN1 and BSPDN2.

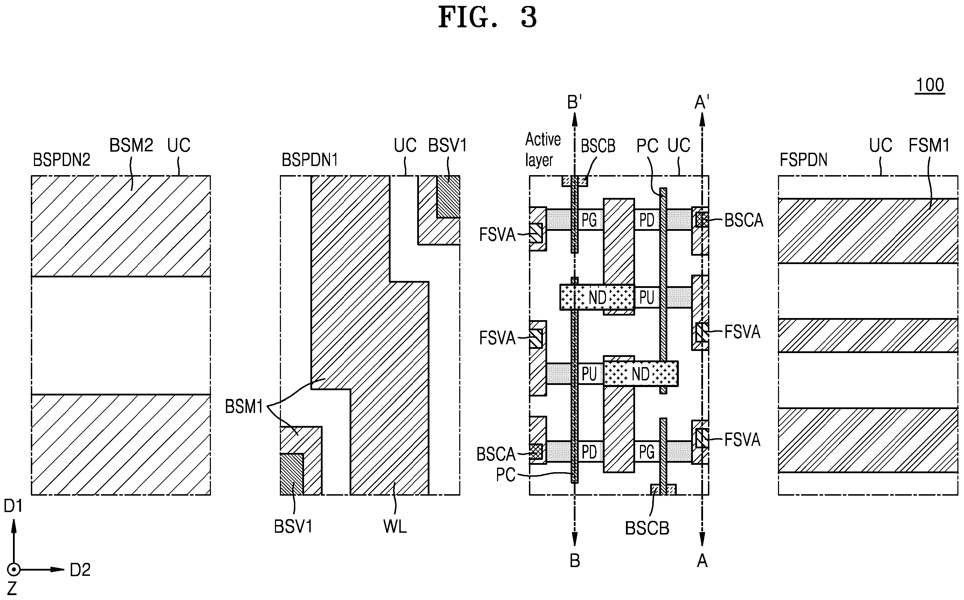

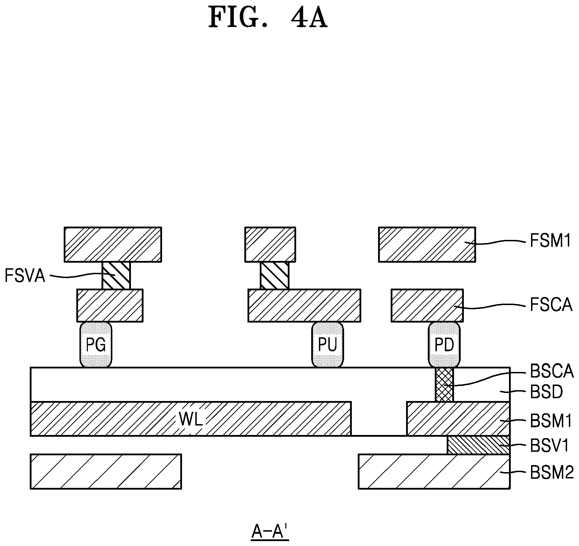

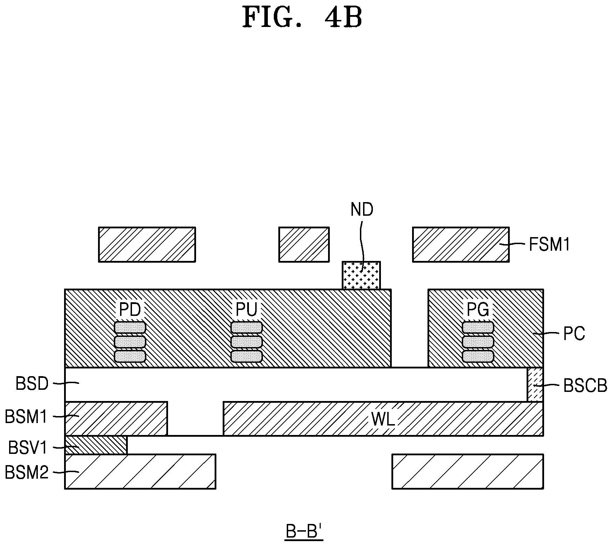

Hereinafter, a planar layout and three-dimensional structure of the integrated circuit 20 of the present embodiment are described with reference to FIGS. 3, 4A, and 4B.

FIG. 3 is a planar layout illustrating a unit cell of an integrated circuit device according to some embodiments.

Referring to FIG. 3, in an integrated circuit 100, the planar layout of a stack structure for a unit cell UC corresponding to 1-bit is shown, and a rectangular portion of the dashed-dotted line may correspond to the unit cell UC of 1-bit. A unit cell of 1-bit may be an individual storage element (e.g. a memory cell) configured to store 1-bit of data.

Here, the second back-side power delivery network BSPDN2, the first back-side power delivery network BSPDN1, the transistor layer (active layer), and the front-side power delivery network FSPDN are in a stack structure in a vertical direction (Z), as described in FIG. 2. However, for convenience of description, the stack structure is shown on a single plane.

For example, the semiconductor substrate on which the transistor layer (active layer) is formed is a silicon (Si) wafer and may include, for example, single crystal silicon, polycrystalline silicon, or amorphous silicon. However, a material of the semiconductor substrate is not limited to Si. In some embodiments, the semiconductor substrate may include a Group IV semiconductor such as germanium (Ge), a Group IV compound semiconductor such as silicon germanium (SiGe) or silicon carbide (SiC), or a Group III-V compound semiconductor such as gallium arsenide (GaAs), indium arsenide (InAs), or indium phosphide (InP).

Although not shown, a shallow trench isolation (STI) defining fins of a fin-type active pattern and a device isolation film defining a device area may be formed on the semiconductor substrate. The device isolation film may be formed deeper than the STI. Here, a cross-section of a shape of a fin-type active pattern may include transistors formed of a structure such as a multi bridge channel field-effect transistor (FET; MBCFET), fin FET (FinFET), forksheet, nano-wire, complementary FET (CFET). However, in the inventive concept, for convenience of description, the cross-section of a shape of a fin-type active pattern has the shape of MBCFET. For each transistor, a gate line may be formed around a channel area of the transistor. This may be achieved by forming the gate line above, below and/or along one or more sides of one or more portions of the channel area. For instance, one or more portions of the channel area may protrude into the gate line. First, referring to a portion showing the transistor layer (active layer), each of a plurality of gate patterns may include a plurality of pull-up transistors PU, a plurality of nodes ND, a plurality of pass gate transistors PG, and a plurality of pull-down transistors PD.

The front-side power delivery network FSPDN may include a plurality of first upper lines FSM1 that extend in a second direction D2 and are spaced apart from each other. The second direction may run perpendicular to the vertical direction (e.g. may be a horizontal direction). The first upper lines FSM1 may include metal. Some of the first upper lines FSM1 may be included in the bit line BL and the bit line bar BLB, and other portions may be lines for applying a positive supply voltage VDD. In some embodiments, the first upper line FSM1 may be composed of two lines each responsible for the bit line BL and one line disposed therebetween for application of the positive supply voltage VDD, and may be formed to have a total of three lines.

A plurality of first lower lines BSM1 may be included in the first back-side power delivery network BSPDN1. The plurality of first lower lines BSM1 may include a jog pattern line and an island pattern line, which is formed to be spaced apart from the jog pattern line. In an integrated circuit device of the inventive concept, a lower portion of a gate of a pass gate transistor PG may be electrically connected to a jog pattern line of the first back-side power delivery network BSPDN1, and a lower portion of a source of the pull-down transistor PD may be electrically connected to an island pattern line of the first back-side power delivery network B SPDN 1.

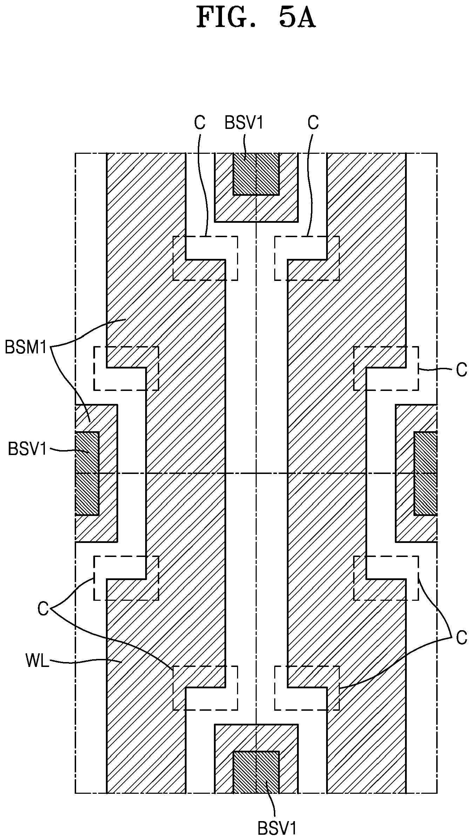

In some embodiments, the jog pattern line and the island pattern line may be formed at the same vertical level. In some embodiments, the jog pattern line may be included in a word line WL. In some embodiments, the jog pattern line may have concavo-convex portions formed in the second direction D2 and extending in a first direction D1. The first direction may be perpendicular to the vertical direction (e.g. may be a horizontal direction). The first direction D1 may be perpendicular to the second direction D2. In some embodiments, the island pattern line may be implemented in an empty space formed by the jog pattern lines, forming two island pattern lines per unit cell UC. In some embodiments, the integrated circuit device of the inventive concept may share an island pattern line with an adjacent cell. In this case, a shape of the island pattern line formed by the adjacent cells is described below with reference to FIG. 5A.

The island pattern line may be formed to be in contact with a lower contact BSV1. The lower contact BSV1 may overlap the island pattern line in the vertical direction (Z direction) and, in a plan view (e.g. when viewed along the vertical direction), may be included in an area formed by the island pattern line. Through the lower contact BSV1, the island pattern line may be electrically connected to a second lower line BSM2 of the second back-side power delivery network BSPDN2, which is described below.

The second back-side power delivery network BSPDN2 may include a plurality of second lower lines BSM2 that extend in the second back-side power delivery network BSPDN2 and are spaced apart from each other. The extension direction may be the same direction as a direction in which a channel is formed in the integrated circuit device of the inventive concept (e.g. the second direction D2). The second lower lines BSM2 may include metal. In some embodiments, the second lower line BSM2 may be a line responsible for a negative supply voltage VSS. In some embodiments, two second lower lines BSM2 may be included per unit cell UC. As described above, each second lower line BSM2 may be electrically connected to a corresponding island pattern line through a corresponding lower contact BSV1. The island pattern line formed in the first back-side power delivery network BSPDN1 may overlap a second lower wiring line of the second back-side power delivery network BSPDN2 in the vertical direction (Z direction) and may be, in a plan view, included in an area formed by the second lower wiring line.

FIG. 4A is a cross-sectional view corresponding to line A-A' in FIG. 3, and FIG. 4B is a cross-sectional view corresponding to line B-B' in FIG. 3.

Referring to FIGS. 4A and 4B together, it can be seen that transmission of an electrical signal is implemented in the integrated circuit device of the inventive concept through implementation of a first lower contact BSCA and a second lower contact BSCB. When viewed from the vertical direction (Z direction), the first lower contact BSCA may be formed on the island pattern line, and the second lower contact BSCB may be formed on the word line WL. The first lower contact BSCA may be formed on the island pattern to transmit the negative supply voltage VSS. The second lower contact BSCB may be formed on the word line WL to transmit the positive supply voltage VDD. A layer formed to surround the first lower contact BSCA and the second lower contact BSCB at the same vertical level as the first lower contact BSCA and the second lower contact BSCB may be an insulating layer BSD that is formed on the rear side of the substrate.

In some embodiments, the first upper lines FSM1 of the front-side power delivery network FSPDN may be respectively electrically connected to sources of the pass gate transistor PG and the pull-up transistor PU through first vias FSVA and upper contacts FSCA. The first via FSVA may be adjacent to the corresponding upper contact FSCA and may be formed to physically and/or electrically connect the upper contact FSCA to the first upper line FSM1 at a higher vertical level than the upper contact FSCA.

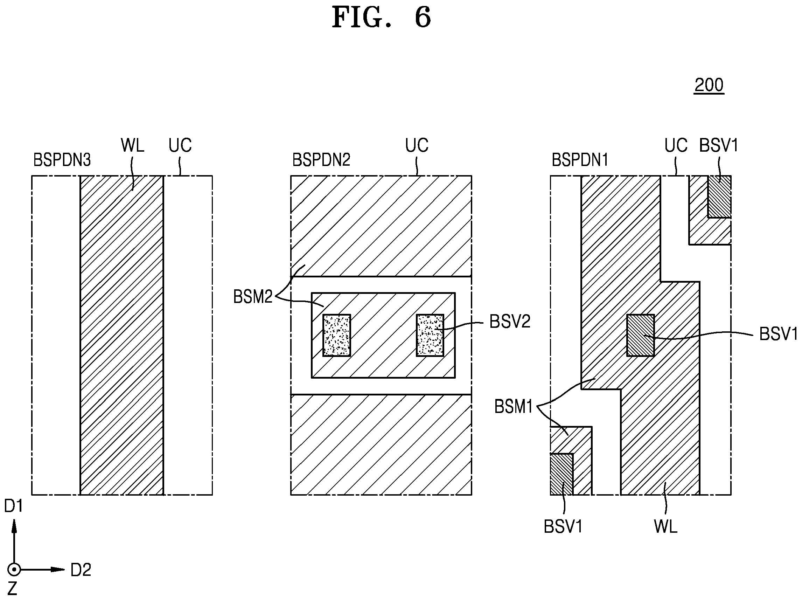

Although not shown in FIGS. 4A and 4B, a second front-side power delivery network FSPDN2, a third front-side power delivery network FSPDN3, or more front-side power delivery networks may be provided at a higher vertical level than the front-side power delivery network FSPDN, to implement an additional structure. Similarly, a third back-side power delivery network BSPDN3, a fourth back-side power delivery network BSPDN4, or more back-side power delivery networks may be provided at a lower vertical level than the second back-side power delivery network BSPDN2, to implement an additional structure, which is described below with reference to FIG. 6.

In the integrated circuit 100 according to the inventive concept, referring to the layout of FIG. 3 showing the unit cell UC of 1-bit, the positive supply voltage VDD may be supplied and connected through the first upper line FSM1 of the front-side power delivery network FSPDN, and the negative supply voltage VSS may be supplied and connected to the first lower line BSM1 and the second lower line BSM2 of the first back-side power delivery network BSPDN1 and the second back-side power delivery network BSPDN2 that overlap each other in the vertical direction (Z direction). Thus, in the integrated circuit device of the inventive concept, a line responsible for the negative supply voltage VSS is disposed under the substrate, so that line margin may be reduced and ease of manufacturing process may be improved.

In the integrated circuit 100 according to the inventive concept, a line responsible for the positive supply voltage VDD and a line responsible for the negative supply voltage VSS are disposed at different vertical levels from each other, so that process difficulty increasing with a complexity of a line connection structure and short circuits occurring between adjacent lines may be improved.

Similarly, the word line WL, which transmits a signal to the gate of the pass gate transistor PG, and the bit line BL and the bit line bar BLB, which are electrically connected to sources of the plurality of pass gate transistors PG, are disposed at different vertical levels from each other, to eliminate an interference phenomenon that may occur between lines for transmitting a signal, thereby improving a signal transmission delay problem.

Ultimately, according to the inventive concept, the integrated circuit 100 with improved electrical reliability may be implemented through a layout of a three-dimensional stack structure (3DS) that may simply configure a line connection structure of transistors included in an SRAM device. Therefore, the inventive concept may be particularly utilized in a layout of an SRAM device including six transistors.

In the inventive concept, a cross-section of each of the figures is implemented based on a MBCFET including three layers. However, the inventive concept is not limited thereto, and the inventive concept may be implemented in the form of an MBCFET implemented with nanosheets in which one or two layers or four or more layers are stacked. In addition, the inventive concept may also be applied when forming an SRAM cell by using six transistors in a forksheet, 3D-FET-based form.

Because a metal line pattern formed under a substrate is a main feature of the inventive concept, in addition to MBCFET (or gate-all-around FET (GAAFET)) that is implemented in stacked nanosheets as an example one of the embodiments, a channel form in which the inventive concept is implemented, such as three-dimensional stacked FET (3DSFET) or FinFET, may vary and may be applied to all FSPDN and/or BSPDN structures in which lines are disposed under and over a substrate in an SRAM cell including more than six transistors. FIG. 5A is a 4-bit layout diagram briefly illustrating example shapes of a jog pattern line and an island pattern line according to some embodiments, formed between unit cells that are adjacent to each other.

Referring to FIG. 5A, a jog pattern line extending within a single unit cell may be integrally connected to another jog pattern that is formed in a unit cell in a direction in which a jog pattern extends. In addition, an island pattern line formed within a single unit cell may be integrally connected to an island pattern formed in an adjacent unit cell. The jog pattern line may be formed in an origin-symmetric form with respect to a jog pattern line, which is formed in another adjacent unit cell, and an island pattern line. For instance, an axis of symmetry may run between two adjacent jog pattern lines, passing through the center of island patterns formed between the two adjacent jog pattern lines. The axis of symmetry may be located halfway between the two adjacent jog pattern lines. The two adjacent jog pattern lines may be symmetrical with each other about the axis of symmetry. A characteristic concavo-convex portion at which a jog pattern is formed may be understood with reference to region C. A direction in which the concavo-convex portion is formed may be formed in a direction perpendicular to a direction in which the jog pattern extends. Due to the jog pattern including the concavo-convex portion, an empty space is formed in the unit cell, and an island pattern may be formed in the empty space. In some embodiments, the island pattern and the jog pattern may be simultaneously formed in a process of forming an integrated circuit device, but the inventive concept is not limited thereto.

As shown in FIG. 5A, in an integrated circuit device according to the technical idea of the inventive concept, a word line WL is implemented in a jog type including concavo-convex portions rather than in the form of a line extending in a specific direction, and the island pattern may be arranged in an empty space generated due to the word line WL. An island pattern line that is in contact with the lower contact BSV1 and transfers an electrical signal and a word line WL having a jog pattern may be used to supply power. As shown in FIG. 5A, each word line has a zig-zag or crenelated shape. Each word line extends in an extension direction (e.g. the first direction D1); however, it includes concavo-convex portions that result in portions that extend laterally (e.g. in the second direction D2). An island pattern line is positioned within each concave section. Each word line therefore bends around a corresponding series of island pattern lines. Given the zig-zag pattern of the word line, island patterns lines alternate on opposite sides of the word line. The concavo-convex portions alternate their direction of protrusion, in order, down the length of the word line.

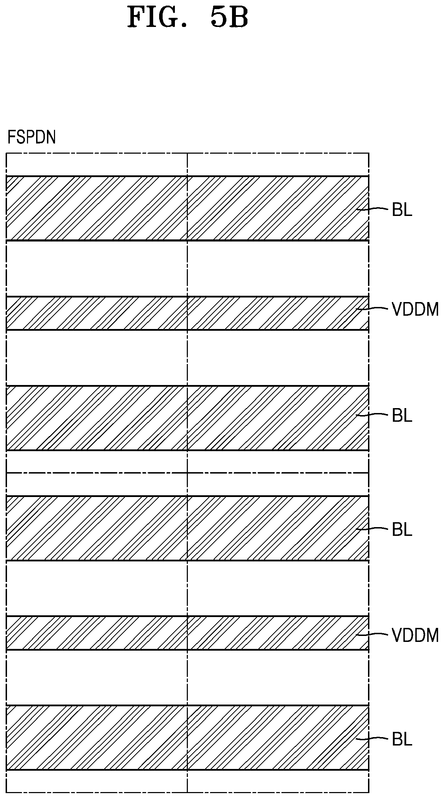

FIG. 5B is a 4-bit layout diagram briefly illustrating an example shape of an upper wiring line according to some embodiments, formed between four mutually adjacent unit cells UC.

Referring to FIG. 5B, a first upper line extending within a single unit cell may be integrally connected to another first upper line that extends within a unit cell in a direction in which the first upper line extends. In addition, three first upper lines may be arranged in a single unit cell, and the first upper lines may each include a bit line BL, a bit line bar BLB, and a positive supply voltage line VDDM that is responsible for a positive supply voltage VDD, the positive supply voltage line VDDM being arranged between the bit line BL and the bit line bar BLB. For each row of unit cells, three upper lines may extend across the row. As a result, in the 4-bit layout diagram, the first upper line may include six lines that are spaced apart from each other and extend in the same direction, and the six lines may include two bit lines BL, two bit line bars BLB, and two positive supply voltage lines VDDM (corresponding to two rows of unit cells).

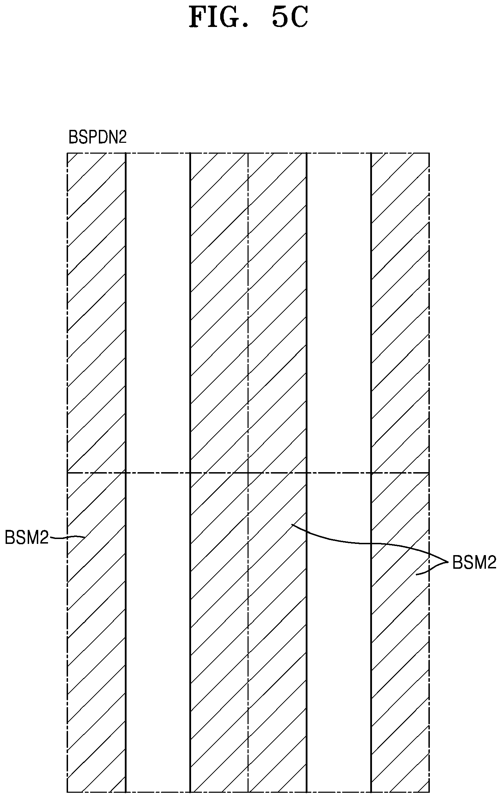

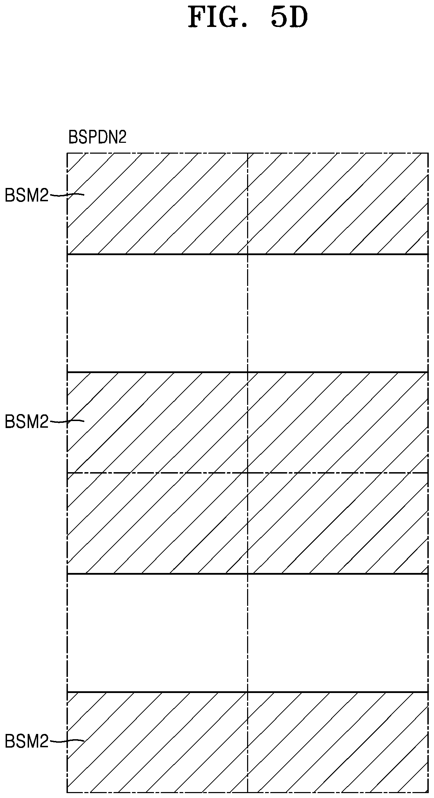

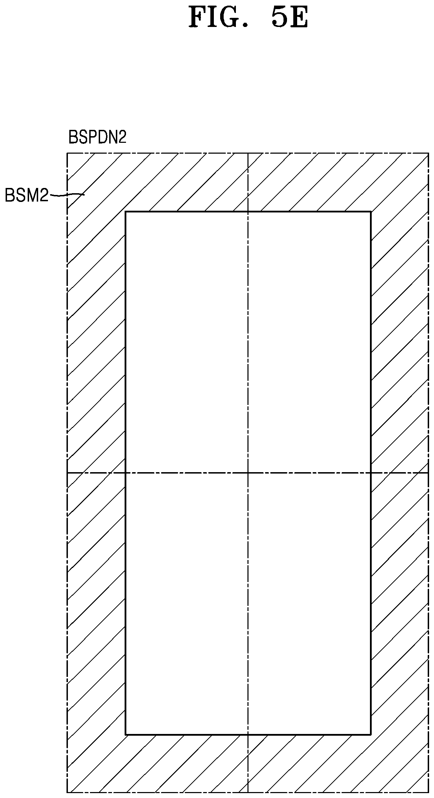

FIGS. 5C, 5D, and 5E are 4-bit layout diagrams briefly illustrating an example shape of a second lower line BSM2 according to some embodiments, formed between mutually adjacent unit cells UC.

First, referring to FIG. 5C, a second lower line BSM2 extending in a direction in which the word line WL (see FIG. 5A) extends within a single unit cell may be integrally connected to another second lower line BSM2 that extends within a unit cell in a direction in which the second lower line extends. The integrally connected second lower lines BSM2 may alternatively be considered a single second lower line BSM2 that is shared between two unit cells (e.g. two adjacent columns of unit cells). In other words, in a single unit cell, two second lower lines BSM2 are arranged spaced apart from each other (e.g. at opposite edges of the unit cell) to extend in the same direction in which the word line WL (see FIG. 5A) of a jog pattern extends, and as a result, in the 4-bit layout diagram of the second back-side power delivery network BSPDN2, it may be shown that a total of three second lower lines BSM2 extend. Due to the lower contact BSV1 (see FIG. 5A) described above, the second lower lines BSM2 may be electrically connected to an island pattern line of the first back-side power delivery network B SPDN 1.

Next, referring to FIG. 5D, the second lower line BSM2 may extend in a direction perpendicular to a direction in which the word line WL (see FIG. 5A) of the jog pattern extends. This may be an example embodiment corresponding to the second back-side power delivery network BSPDN2 shown in FIG. 3. The second lower line extending within a single unit cell may be integrally connected to another second lower line that extends within a unit cell in a direction in which the second lower line extends. The integrally connected second lower lines BSM2 may alternatively be considered a single second lower line BSM2 that is shared between two unit cells (e.g. two adjacent rows of unit cells). As a result, in the 4-bit layout diagram, it may be shown that a total of three second lower lines BSM2 extend. Due to the lower contact BSV1 (see FIG. 5A) described above, the second lower lines BSM2 may be electrically connected to the island pattern line of the first back-side power delivery network BSPDN1.

Referring to FIG. 5E, the second lower line BSM2 may be formed in the same direction as or in a direction perpendicular to the direction in which the word line WL (see FIG. 5A) extends. According to the example embodiment described above, based on a single unit cell, it may be shown that the second lower line BSM2 is formed in an "L" shape along one edge. Based on the 4-bit layout diagram, it may be shown that four unit cells have a mutually symmetrical pattern and the second lower line BSM2 is formed in a rectangular shape along an outer edge of the 4-bit layout diagram. Due to the lower contact BSV1 (see FIG. 5A) described above, the second lower lines BSM2 may be electrically connected to the island pattern line of the first back-side power delivery network BSPDN1.

In FIGS. 5C to 5E, shapes that may be represented by the second lower line BSM2 in the second back-side power delivery network BSPDN2 in the 4-bit layout diagram are shown. However, these are only examples, and a pattern in which the second lower line BSM2 may be arranged is not limited thereto.

FIG. 6 is a planar layout diagram illustrating a unit cell of an integrated circuit device according to some embodiments.

Referring to FIG. 6, in an integrated circuit 200, a planar layout of a stack structure for a unit cell UC corresponding to 1-bit is shown, and a rectangular portion of the dashed-dotted line may correspond to the unit cell UC of 1-bit.

In the integrated circuit 200 in FIG. 6, it may be understood that the same member as that of the integrated circuit 200 in FIG. 3 indicates the same configuration as that of the integrated circuit 100 in FIG. 3. In the integrated circuit 200 in FIG. 6, for convenience of description, a transistor layer (active layer) and a front-side power delivery network FSPDN are omitted. It may be understood that the transistor layer (active layer) and the front-side power delivery network FSPDN are identical or similar to those of the integrated circuit 100 in FIG. 3. Hereinbelow, descriptions overlapping those of the integrated circuit 100 described with reference to FIG. 3 are omitted, and differences are mainly described.

The integrated circuit 200 in FIG. 6 may further include a third back-side power delivery network BSPDN3 that is disposed at a lower vertical level than the second back-side power delivery network BSPDN2. In other words, it may be understood that the third back-side power delivery network BSPDN3, the second back-side power delivery network BSPDN2, and the first back-side power delivery network BSPDN1 are sequentially stacked by overlapping one another in the vertical direction (Z direction).

The first back-side power delivery network BSPDN1 may include the first lower line BSM1, and the first lower line BSM1 may include a jog pattern line and a first island pattern line. In some embodiments, the jog pattern line may be a word line WL. The jog pattern line may have concavo-convex portions formed in the second direction D2 and may extend in a first direction D1. A concavo-convex portion formed in the second direction D2 in the jog pattern line of the first lower line BSM1 may be electrically coupled to the second lower line BSM2 of the second back-side power delivery network BSPDN2 through the first lower contact BSV1. The first lower contact BSV1 may overlap a second island pattern line in the vertical direction (Z direction) and, in a plan view, may be included in an area formed by the second island pattern line. In FIG. 6, two first lower contacts BSV1 on the jog patterns are formed per unit cell UC. However, this is only an example, and the inventive concept is not limited to the number, shape, or size of the first lower contact BSV1.

In some embodiments, the first island pattern line may be implemented in an empty space formed by the jog pattern lines, forming two island pattern lines per unit cell UC. In some embodiments, the integrated circuit device of the inventive concept may share the first island pattern line with an adjacent cell. In this case, a shape of the island pattern line formed by the adjacent cells is described above with reference to FIG. 5A.

In some embodiments, the first island pattern line may be electrically coupled to the second lower line BSM2 of the second back-side power delivery network BSPDN2 through the first lower contact BSV1.

The first island pattern line may be formed to be in contact with the first lower contact BSV1. The first lower contact BSV1 may overlap the first island pattern line in the vertical direction (Z direction) and, in a plan view, may be included in an area formed by the first island pattern line.

The second back-side power delivery network BSPDN2 may include the second lower line BSM2, and the second lower line BSM2 may include two wiring lines that extend in the second direction D2 and a second island pattern line arranged between the two wiring lines, the second direction D2 being perpendicular to the first direction D1 in which a jog pattern line extends. In this case, the second lower line BSM2 electrically connected to the first island pattern line through the first lower contact BSV1 may include two wiring lines. In some embodiments, the two wiring lines may be formed to be physically spaced apart from the jog pattern line. In some embodiments, the first island pattern line may be formed to be physically spaced apart from the second pattern line.

In this case, the jog pattern of the first lower line BSM1 and the second island pattern line may be electrically connected to each other through the first lower contact BSV1. In some embodiments, the second island pattern line may be in electrical contact with a third lower wiring line in the third back-side power delivery network BSPDN3 through a second lower contact BSV2. The second island pattern line may be formed to be in contact with the second lower contact BSV2. The second lower contact BSV2 may overlap the second island pattern line in the vertical direction (Z direction) and, in a plan view, may be included in an area formed by the second island pattern line. In FIG. 6, two second lower contacts BSV2 are formed per unit cell UC. However, this is only an example, and the inventive concept is not limited to the number, shape, or size of the second lower contact BSV2.

In some embodiments, the third lower wiring line may be a linear line that extends in the same direction as the first direction D1, in which a jog pattern line extending from the first back-side power delivery network BSPDN1 extends. The third lower wiring line may be integrally formed with a third lower wiring line of an adjacent unit cell and may have a continuous shape. The third lower wiring line may be represented as a word line WL. As a result, the jog pattern line formed in the first back-side power delivery network BSPDN1 and the word line WL formed in the third back-side power delivery network BSPDN3 may be electrically connected to each other.

Referring to the integrated circuit 200 in FIG. 6, in the inventive concept, a line responsible for the negative supply voltage VSS is disposed under a substrate, so as to be arranged at a vertical level different from that of a line responsible for the positive supply voltage VDD. In addition, the word line WL is arranged at different vertical levels (BSPD1 and BSPD3), so that a line margin of the integrated circuit device may be reduced.

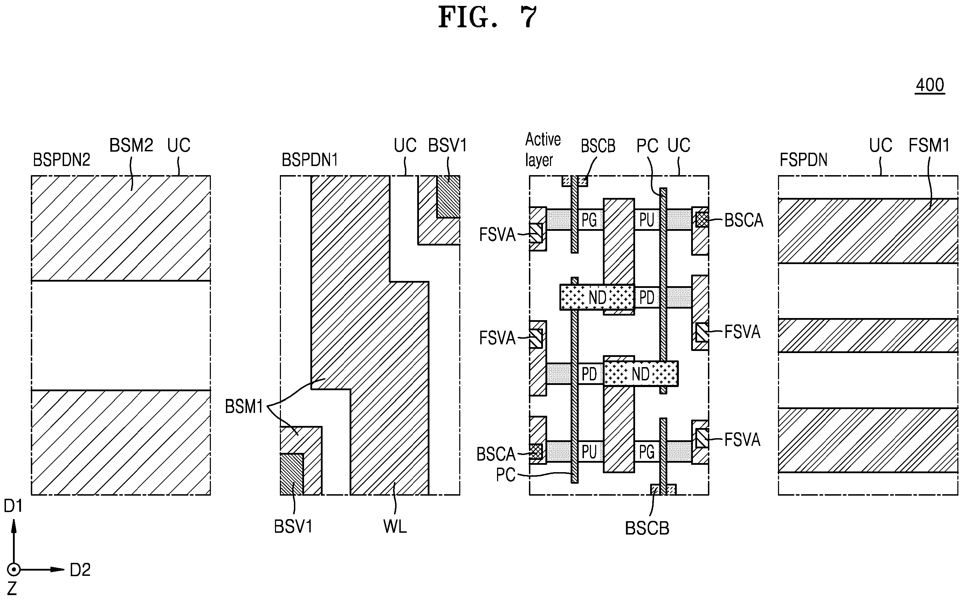

FIG. 7 is a planar layout illustrating a unit cell of an integrated circuit device according to some embodiments.

Referring to an integrated circuit 400 in FIG. 7, unlike the integrated circuit 100 (see FIG. 3) that includes two pMOSFETs and four nMOSFETs, most of elements may be understood the same as or similar to the integrated circuit 100 in FIG. 3, except for including two nMOSFETs and four pMOSFETs.

When positions of the pull-up transistor PU and the pull-down transistor PD are switched compared to the integrated circuit 100 in FIG. 3 and the pass gate transistor PG is formed as a pMOSFET, the line responsible for the positive supply voltage VDD in FIG. 3 may function as a line responsible for the negative supply voltage VSS in FIG. 7, and the line responsible for the negative supply voltage VSS in FIG. 3 may function as a line responsible for the positive supply voltage VDD in FIG. 7. In other words, in the front-side power delivery network FSPDN, a portion of the first upper wiring line FSM1 may be responsible for the negative supply voltage VSS, and a portion responsible for the positive supply voltage VDD may be arranged in the first and second back-side power delivery networks BSPDN1 and BSPDN2. In this case as well, the first lower line BSM1 formed in the first back-side power delivery network BSPDN1 may include an island pattern line and a jog pattern line.

In an integrated circuit device including the integrated circuit 400 in FIG. 7, the line responsible for the negative supply voltage VSS is disposed over the substrate, and the line responsible for the positive supply voltage VDD may be disposed under the substrate, so that reduction in line margin may be expected.

While the inventive concept has been particularly shown and described with reference to embodiments thereof, it will be understood that various changes in form and details may be made therein without departing from the scope of the following claims.

## Claims

1. An integrated circuit device comprising:
a fin-type active area on a substrate;
a channel area in the fin-type active area;
a gate line that extends around the channel area;
a plurality of first upper lines that electrically connect the channel area and the gate line to each other;
a plurality of first lower lines below the substrate; and
a second lower wiring line below the plurality of first lower lines,
wherein the plurality of first lower lines comprise a jog pattern line and an island pattern line that is spaced apart from the jog pattern line, and
wherein the island pattern line is electrically connected to the second lower wiring line by a lower contact.

2. The integrated circuit device of claim 1, wherein the jog pattern line extends in a first direction that is perpendicular to a second direction in which the plurality of first upper lines extend.

3. The integrated circuit device of claim 2, wherein the lower contact overlaps the island pattern line in a third direction that intersects the first direction and the second direction,
wherein the lower contact is, in a plan view, included in an area formed by the island pattern line.

4. The integrated circuit device of any preceding claim, wherein the jog pattern line is electrically connected to a gate of a transistor, and
wherein the island pattern line is electrically connected to a source region of the transistor.

5. The integrated circuit device of any preceding claim, wherein the jog pattern line comprises a first jog pattern line in a first unit cell,
wherein the first jog pattern line is origin-symmetric with respect to a second jog pattern line, which is in a second unit cell that is adjacent to the first unit cell, and
wherein the first jog pattern line is origin-symmetric with respect to the island pattern line.

6. The integrated circuit device of any preceding claim, wherein the island pattern line overlaps the second lower wiring line in plan view.

7. The integrated circuit device of any preceding claim, wherein some of the first upper lines are configured to receive a voltage that is different to a voltage applied to the island pattern line and the second lower wiring line.

8. The integrated circuit device of any preceding claim, wherein the plurality of first upper lines comprise three first upper lines per unit cell.

9. The integrated circuit device of any preceding claim, wherein six or more transistors are included per unit cell.

10. The integrated circuit device of any preceding claim, wherein the jog pattern line and the island pattern line are electrically isolated from each other.

11. The integrated circuit device of any preceding claim, wherein the j og pattern line is spaced apart from the second lower wiring line.

12. The integrated circuit device of any preceding claim, wherein the second lower wiring line extends in a same direction as a direction in which the plurality of first upper lines extend.

13. The integrated circuit device of claim 12, wherein the second lower wiring line comprises two second lower wiring lines per unit cell.

14. An integrated circuit device according to any preceding claim, comprising:
the substrate, wherein the substrate has a front surface and a rear surface that are opposite to each other, and the fin-type active area is on the front surface and is adjacent a trench;
source/drain regions on the fin-type active area;
gate electrodes that extend across the fin-type active area;
a third lower wiring line below the second lower wiring line,
wherein:
the plurality of first upper lines are on the source/drain regions and are electrically connected to the source/drain regions by at least one via;
the second lower wiring line is on a side of a second island pattern line;
the island pattern line is a first island pattern line and the lower contact is a first lower contact,
the first island pattern line is electrically connected to the third lower wiring line by the first lower contact, and
the jog pattern line is electrically connected to the second island pattern line by the first lower contact, and is electrically connected to the third lower wiring line by a second lower contact.

15. The integrated circuit device of claim 14, wherein the third lower wiring line and the jog pattern line extend in a first direction that is perpendicular to a second direction in which the plurality of first upper lines extend.

## Amended claims

### Amended claims in accordance with Rule 137(2) EPC.

1. An integrated circuit device (100) comprising:
a fin-type active area on a substrate;
a channel area in the fin-type active area;
a gate line that extends around the channel area;
a plurality of upper lines (FSM1), wherein a said upper line is configured to apply a first supply voltage and further said upper lines are configured to electrically connect the channel area and the gate line to each other;
a plurality of first lower lines (BSM1) below the substrate; and
a second lower wiring line (BSM2), configured to apply a second supply voltage, wherein the second lower wiring line (BSM2) is below the plurality of first lower lines (BSM1),
wherein the plurality of first lower lines (BSM1) comprise a jog pattern line and an island pattern line that is spaced apart from the jog pattern line, and
wherein the island pattern line is electrically connected to the second lower wiring line by a lower contact (BSV1).

2. The integrated circuit device of claim 1, wherein the jog pattern line extends in a first direction (D1) that is perpendicular to a second direction (D2) in which the plurality of upper lines (FSM1) extend.

3. The integrated circuit device of claim 2, wherein the lower contact (BSV1) overlaps the island pattern line in a third direction (D3) that intersects the first direction (D1) and the second direction (D2),
wherein the lower contact (BSV1) is, in a plan view, included in an area formed by the island pattern line.

4. The integrated circuit device of any preceding claim, wherein the jog pattern line is electrically connected to a gate of a transistor, and
wherein the island pattern line is electrically connected to a source region of the transistor.

5. The integrated circuit device of any preceding claim, wherein the jog pattern line comprises a first jog pattern line in a first unit cell (UC),
wherein the first jog pattern line is origin-symmetric with respect to a second jog pattern line, which is in a second unit cell (UC) that is adjacent to the first unit cell (UC), and
wherein the first jog pattern line is origin-symmetric with respect to the island pattern line.

6. The integrated circuit device of any preceding claim, wherein the island pattern line overlaps the second lower wiring line in plan view.

7. The integrated circuit device of any preceding claim, wherein some of the upper lines (FSM1) are configured to receive a voltage that is different to a voltage applied to the island pattern line and the second lower wiring line.

8. The integrated circuit device of any preceding claim, wherein the plurality of upper lines (FSM1) comprise three upper lines (FSM1) per unit cell (UC).

9. The integrated circuit device of any preceding claim, wherein six or more transistors are included per unit cell (UC).

10. The integrated circuit device of any preceding claim, wherein the jog pattern line and the island pattern line are electrically isolated from each other.

11. The integrated circuit device of any preceding claim, wherein the jog pattern line is spaced apart from the second lower wiring line.

12. The integrated circuit device of any preceding claim, wherein the second lower wiring line extends in a same direction as a direction in which the plurality of first lines (FSM1) extend.

13. The integrated circuit device of claim 12, wherein the second lower wiring line comprises two second lower wiring lines per unit cell (UC).

14. An integrated circuit device according to any preceding claim, comprising:
the substrate, wherein the substrate has a front surface and a rear surface that are opposite to each other, and the fin-type active area is on the front surface and is adjacent a trench;
source/drain regions on the fin-type active area;
gate electrodes that extend across the fin-type active area;
a third lower wiring line below the second lower wiring line,
wherein:
the plurality of upper lines (FSM1) are on the source/drain regions and are electrically connected to the source/drain regions by at least one via;
the second lower wiring line is on a side of a second island pattern line;
the island pattern line is a first island pattern line and the lower contact is a first lower contact (BSV1),
the first island pattern line is electrically connected to the third lower wiring line by the first lower contact (BSV1), and
the jog pattern line is electrically connected to the second island pattern line by the first lower contact (BSV1), and is electrically connected to the third lower wiring line by a second lower contact (BSV2).

15. The integrated circuit device of claim 14, wherein the third lower wiring line and the jog pattern line extend in a first direction (D1) that is perpendicular to a second direction (D2) in which the plurality of upper lines (FSM1) extend.
